(19) **Europäisches Patentamt European Patent Office Office européen des brevets**

(11) **EP 2 767 842 B1**

(12) **EUROPEAN PATENT SPECIFICATION**

(45) Date of publication and mention of the grant of the patent:
**08.04.2015 Bulletin 2015/15**

(51) Int Cl.:
*G01R 31/36* <sup>(2006.01)</sup>    *H02J 7/00* <sup>(2006.01)</sup>

(21) Application number: **13305171.4**

(22) Date of filing: **14.02.2013**

(54) **State of charge estimation based on battery discharge model**

Ladestatusschätzung auf Grundlage des Batterieentladungsmodells

Estimation d'état de charge basée sur un modèle de décharge de batterie

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**20.08.2014 Bulletin 2014/34**

(73) Proprietor: **ST-Ericsson SA 1228 Plan-les-Ouates (CH)**

(72) Inventor: **Ladret, Daniel 38250 Lans-en-Vercors (FR)**

(74) Representative: **Hirsch & Associés 137, rue de l'Université 75007 Paris (FR)**

(56) References cited:
EP-A2- 2 020 723    WO-A1-2008/024748
US-A1- 2008 215 265    US-A1- 2010 217 552
US-A1- 2011 234 167    US-A1- 2011 234 173

**Description**

FIELD OF THE INVENTION

The invention relates to the field of battery estimation apparatus and more especially to a battery state-of-charge (SoC) indication system.

BACKGROUND OF THE INVENTION

Batteries are used in numerous applications where it is important to know the amount of available energy remaining in the battery.

For example, the battery state-of-charge (SoC) indication is critical for operating battery-energized electric vehicle: the driver needs to know precisely enough when the vehicle will run out of energy. Insufficient accuracy may lead to critical situation, including accidents.

Another example is mobile communication devices (including tablets, smartphones, etc.). The case is less critical, but still the user needs to know when his/her device needs to be plugged for energy loading, so as to avoid the battery being completely discharged and the communication device inoperable.

There is still a need for an accurate indication of the state of charge (SoC) of the battery, so as to display this indication to the user and/or to trigger alerts or actions driven by the battery level.

The indication of the battery charge level is usually given as a "State of Charge" (SoC). The state of charge can be considered as an equivalent of a fuel gauge, providing a numeral value representative of the level of charge of the battery. This indication is usually given in percentage or, less often, in mAh.

In percentage format, 100% means that the battery is full, and 0% means that the battery reached its cut-off voltage, i.e. the minimum allowable voltage, generally defining the "empty" state of the battery. In the use case of mobile communication devices, the cut-off voltage depends on mobile makers and is around 3.0 to 3.2 V.

There are several ways to estimate the battery state-of-charge.

A first way consists in using the pH of the electrolyte as representative of this state of charge. This method is however limited to batteries that offer access to their electrolyte.

Another approach consists in estimating the State of Charge indication as a function of voltage measurements at the outputs of the battery. This function can be implemented as a look-up table, filled with values of voltage associated with values of the SoC and to which the voltage measurements can be compared to determine the appropriate value for the SoC.

However, due to the internal impedance of the battery, the voltage is not easy to measure accurately enough when the consumed current is high. The look-up table needs furthermore to be precisely configured, and short measurement periods should be implemented. In practice, this approach provides poor accuracy.

Still another approach, known as "coulomb counting", calculates the state of charge by periodically measuring the current flowing into the battery through a sense resistor and integrating it in time: accumulation of these current samples gives the total charges that have flown through the battery.

A drawback of such an approach is that it depends on an accurate estimation of the starting point. It requires the counter to be recalibrated on a regular basis, thus further requiring a complete refilling of the battery charge - which is a tough constraint for the user and/or the application.

Another drawback is that it requires the use of an analog-to-digital convertor able to support measurements from milliamps to amps and to keep a negligible consumption in standby. Therefore, the coulomb counter approach can generate an important error when the current to measure is low. Furthermore, as these measurements are integrated over a long period, these errors are accumulated so that the final accuracy ends to be poor.

To improve the situation, it has been proposed to mix the two last approaches.

In general, a threshold is defined to which the current measurements are compared.

When the measured current is below the threshold, the state of charge SoC is calculated according to the "voltage approach" by measuring the voltage and comparing it to a lookup table in which the voltage is directly associated with a value of the State of charge.

When the measured current is above this threshold, the coulomb counter-based approach is used. The state of charge SoC can be simply calculated with the following formula, where the SoC is given as a percentage:

$$SoC = 100 \times \frac{Q_a}{Q_{\max}}$$

Wherein

$Q_a$ represents the available charge of the battery (expressed in coulomb), and $Q_{max}$ represents the maximum charge of the battery.

As previously mentioned, the computation of the available charge can be done through an iterative process by determining charge variations (or discharges) $dq_i$ and to sum them so as to obtain a total charge $Q_i$ corresponding to

the total amount of the charge which has been consumed so far. In other words: $Q_i = \sum_{j=1}^{i} dq_j$

The previous equation becomes:

$$SoC = 100 \times \frac{Q_{max} - Q_i}{Q_{max}}$$

The problem to address is then to compute accurately both $Q_{max}$ and $Q_i$ (or $Q_a$).

Several implementations have been proposed of this generic approach. For instance, the company Texas Instrument has proposed an algorithm called "impedance tracking", and the company Maxim has proposed another algorithm called "3MFuelGauge".

Generally, the battery State of Charge is calculated through a recurrent formula like:

$$SoC_i = SoC_{i-1} - \frac{dq_i}{Q_{max}}$$

Wherein:

$SoC_i$ is the state of charge at a measurement point i;
$dq_i$ is the charge variation between the measurement points i-1 and i. $Q_{max}$ is the maximum charge. This maximum charge is obtained in open-circuit voltage (OCV) conditions.

However, such an algorithm is still unsatisfactory, especially due to its complexity.

As it is an iterative algorithm, each inaccuracy, even small, adds up and at the end the cumulated inaccuracies produce a substantial error. In order to limit this error, the algorithm will use the battery impedance and tries to update regularly the estimated state of charge from a lookup table.

To implement such a process, it is required to take into account the consumption of the battery and the impedance must be measured properly in order to store the values in the lookup table. The temperature is also a critical point because the impedance cannot be easily modeled by an equation: it should be done by providing several lookup tables filled by impedance values at different temperatures.

There is a need for a solution improving further the situation by providing an easier-to-implement algorithm able to produce better accuracy for the estimated State of Charge SoC.

SUMMARY OF THE INVENTION

An object of embodiments of the present invention is to alleviate at least partly the above mentioned drawbacks.

This is achieved with a method for estimating a charge level for a battery comprising the step of using a coulomb counter for estimating the State of Charge of said battery at a given time on the basis of the consumed charge $Q_i$ measured until this given time and on the maximum charge $Q_{max}$ of said battery, wherein said maximum charge is given by:

$$Q_{max} = 60.T_{max} \cdot i_{load},$$

Wherein $T_{max} = 60.[(Q_i/i_{load}) + (K.Q_i/\Delta)]$ and $\Delta = V_{cut\text{-}off} - E_0 + R.i_{load}$, and wherein $i_{load}$ is the measured load current flowing through said battery, $V_{cut\text{-}off}$ is the cut-off voltage of said battery, R is the internal resistance of said battery, $E_0$ is a base voltage of said battery and K is a coefficient of said battery.

According to some embodiments of the invention, the method may comprise one or several of the following features

- said State of Charge is iteratively estimated from its previously estimated value ;
- said state of charge $SoC_i$ is estimated from said previously estimated value $SoC_{i-1}$ by the equation:

$$SoC_i = SoC_{i-1} - \frac{dq_i}{Q_{max}}$$ , wherein $dq_i$ is the product of said measured load current $i_{load}$ by the time between two iterations.

- said coefficient K is determined by the iterative steps of:

  computing an estimated battery voltage $V^*_{bat}$ based on a current value of said coefficient K, from the equation

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

  Wherein Q is the available charge of said battery, t is the time between two iterations and A and B are constant coefficients;
  comparing said estimated voltage to a measured voltage and
  according the comparing step, using the current value of said coefficient K or updating said current value and looping to the computing step.

- said resistance R is determined from a measurement of the temperature.
- an initial value for said State of Charge is determined by

  Determining an open-circuit voltage $V_{OC} = V_{bat} + R.i_{load}$, wherein $V_{bat}$ is a measured battery voltage,
  Determining a corresponding State of Charge from a lookup table.

- said cut-off voltage $V_{cut-off}$ is equal to 3.0 V.

This is also achieved with a computer program product comprising a computer readable medium, having thereon a computer program comprising program instructions, the computer program being loadable into a data-processing unit and adapted to cause execution of this method when the computer program is run by the data-processing unit.

Another aspect of the invention concerns a battery state of charge estimation arrangement for use with a battery comprising:

  a coulomb counter for estimating the State of Charge of said battery at a given time on the basis of the consumed charges $Q_i$ measured until this given time and on the maximum charge $Q_{max}$ of said battery, wherein said maximum charge is given by:

$$Q_{max} = 60.T_{max} \cdot i_{load} ,$$

  Wherein $T_{max} = 60.[(Q_i/i_{load}) + (K.Qi/\Delta)]$ and $\Delta = V_{cut-off} - E_0 + R.i_{load}$, and R is the internal resistance of said battery, $E_0$ is a base voltage of said battery and K is a coefficient of said battery, and,
  means for measuring a load current $i_{load}$ flowing through said battery, a cut-off voltage $V_{cut-off}$ of said battery,

According to some embodiments of the invention, the estimation arrangement may comprise one or several of the following features:

- The estimation arrangement comprises means for having said State of Charge iteratively estimated from its previously estimated value.

- Said state of charge $SoC_i$ is estimated from said previously estimated value $SoC_{i-1}$ by the equation:

$$SoC_i = SoC_{i-1} - \frac{dq_i}{Q_{max}}$$, wherein $dq_i$ is the product of the measured load current $i_{load}$ by the time t between two iterations.

- The estimation arrangement comprises determining means for determining said coefficient K by:

  computing an estimated battery voltage $V^*_{bat}$ based on a current value of said coefficient K, from the equation

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

  Wherein Q is the available charge of said battery, t is the time between two iterations and A and B are constant coefficients;
  comparing said estimated voltage to a measured voltage and means for, according to the result of said comparing, using the current value of said coefficient K, or updating said current value and triggering said determining means.

- The estimation arrangement comprises means for measuring a temperature and means for determining said resistance R from a measurement of said temperature.
- The estimation arrangement comprises means for determining an initial value for said State of Charge by:

  Determining an open-circuit voltage $V_{OC} = V_{bat} + R.i_{load}$, wherein $V_{bat}$ is a measured battery voltage,
  Determining a corresponding State of Charge from a lookup table.

Another aspect of the invention consists in a mobile communication terminal comprising an estimation arrangement as previously defined and a battery.

Further features and advantages of embodiments of the invention will appear from the following description of some embodiments of the invention, given as nonlimiting examples, with reference to the accompanying drawings listed hereunder.

BRIEF DESCRIPTION OF THE DRAWINGS

  FIG. 1 represents a discharge curve according to the model established by C. M. Shepherd.
  FIG. 2 shows that the discharge curve depends on the load current.
  FIGS. 3, 4 and 5 depict flowcharts for possible embodiments of the invention.

DETAILED DESCRIPTION OF EMBODIMENTS OF THE INVENTION

The invention is based on a model for a battery discharge proposed by C.M. Shepherd in 1963 in its report "Theoretical Design of Primary and Secondary Cells - Part III - Battery Discharge Equation", US Naval Research Laboratory (Washington DC), and, later in 1965 in an article "Design of Primary and Secondary Cells" in Journal of The Electrochemical Society, vol. 112, pp. 657-664.

This model is expressed as a mathematical equation, which describes the electrochemical behavior of the battery. This equation can be written as follows:

$$V_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

wherein:

- $V_{bat}$ is the voltage or potential of the battery during the discharge.
- $E_0$ is a base and constant voltage.

- K is a coefficient characterizing the battery.
- $i_{load}$ is the intensity of the load current (in Amperes per battery exchange area)
- Q is the available charge (related to the battery exchange area)
- t is the time
- R is the battery internal resistance
- A and B are constant coefficients.

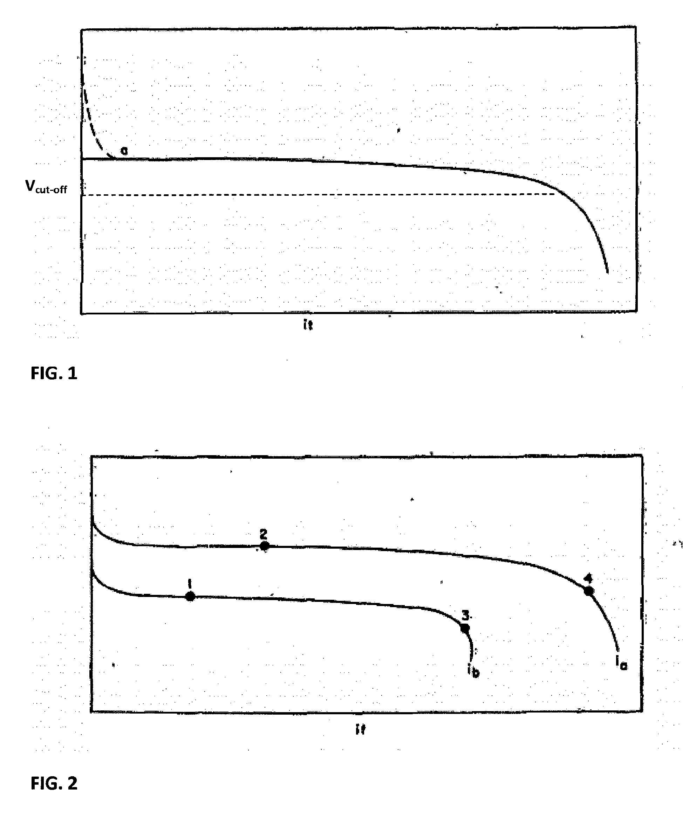

FIG. 1 represents a discharge curve according to this model. It shows the decrease of the voltage $V_{bat}$ according to the quantity of electricity i.t.

The dotted curve represents the contribution of the exponential term, which is mostly relevant for high battery voltage. The solid curve represents the equation without this exponential term. The full equation is therefore represented by the addition of these 2 curves.

After the first rapid drop, the curve shows a linear discharge, until the cut-off voltage. K is representative of the polarization slope of the curve in this area.

FIG. 2 shows that the curve depends on the load current $i_{load}$ (more precisely on its intensity). It depicts two curves for two values $i_a$, $i_b$.

For each of these curves, when one is sufficiently far from the first rapid drop, the exponential part of the previous equation can be neglected. This is for instance the case for points 1, 2, 3 and 4 in FIG. 2, especially for points 3 and 4 which are near to the cut-off voltage $V_{cut-off}$.

This cut-off voltage is a parameter which can be configured for each type of battery. It is usually around 3.0 V.

Then, the equation of the Shepherd's model, provided here above, can be approximated as:

$$V_{cut-off} = E_0 - K \cdot i_{load} \cdot \left( \frac{Q}{Q - i_{load} \cdot t} \right) - R \cdot i_{load}$$

This can be rewritten as:

$$V_{cut-off} - E_0 + R.i_{load} = K \cdot i_{load} \cdot \left( \frac{Q}{Q - i_{load} \cdot t} \right)$$

We can here introduce the parameter $\Delta$, so that

$$V_{cut-off} - E_0 + R.i_{load} = \Delta$$

We can also define the parameter $Q_{max}$ as the maximum charge (in coulomb) of the battery, i.e. when the battery is full. It thus corresponds to a SoC of 100%. This maximum charge can be defined as:

$$Q_{max} = 60.T_{max} \cdot I_{load}$$

Where

$$T_{max} = 60.[(Q_i / I_{load}) + (K.Q_i / \Delta)]$$

and

$$\Delta = V_{cut-off} - E_0 + R.i_{load}$$

$Q_i$ represents the consumed charge along the discharge until the iteration i when the measurements and calculations are done.

As it will be seen later a typical way to implement the SoC calculation is an iterative one, so that a real-time (or nearly real-time) value can be updated at each iteration and provided to the user and/or to the applications. Then, instead of computing the total consumed charge at each iteration, only the differential consumed charge $dq_i = i_{load}.t$ can be computed (i.e. the charge consumed during the time t between two iterations).

The total consumed charge $Q_i$ can be simply provided by summing all the differential consumed charges $dq_i$ until the current iteration (or time) i.

$T_{max}$ is the maximum discharge time.

These expressions enable to get the maximum charge $Q_{max}$ as a function of the consumed charge.

The following algorithms allow determining to needed parameters to get this value $Q_{max}$.

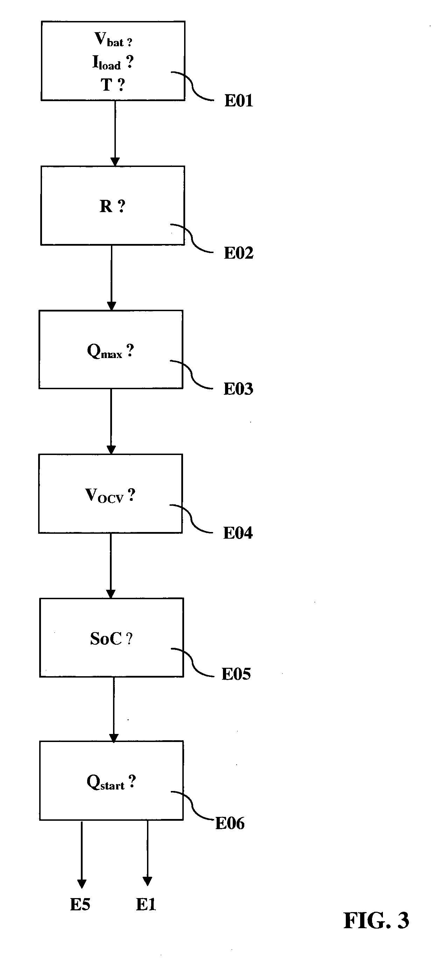

FIGS. 3, 4 and 5 depict flowcharts for possible embodiments of the invention.

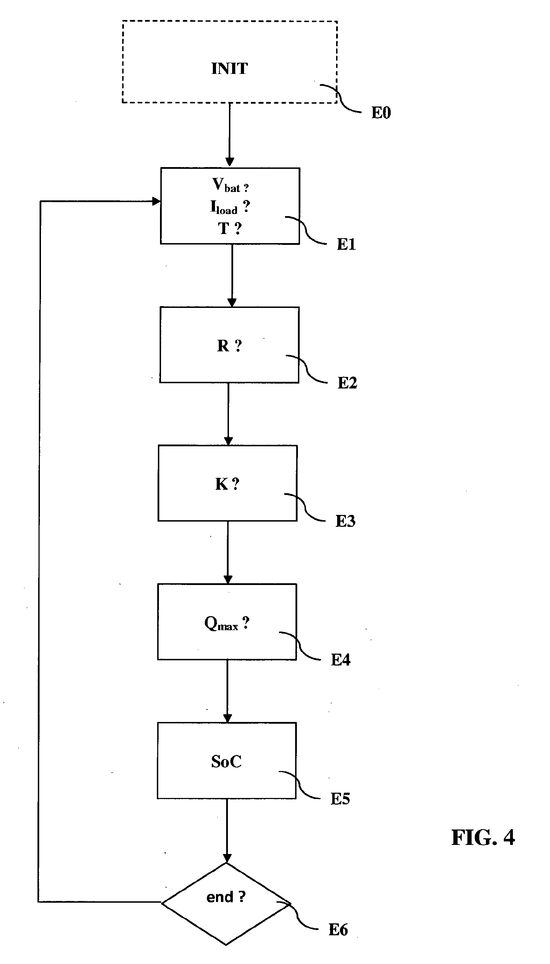

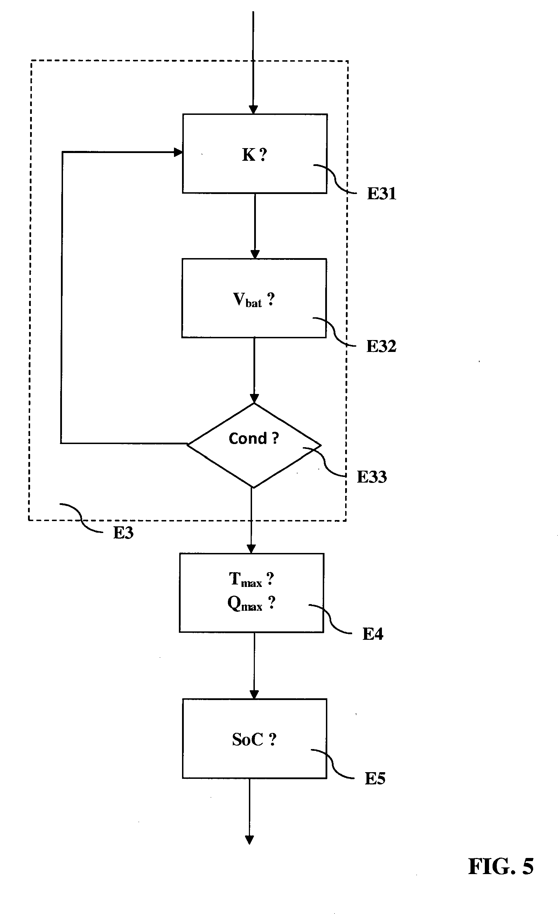

FIG. 3 represents an embodiment of an initialization step, depicted as reference E0 in FIG. 4. FIG. 5 represents an embodiment of the determination of the $Q_{max}$ parameter at step E4 in FIG. 4.

Starting with the initialization process depicted on FIG. 3, the step E01 consists in determining initial values of the voltage or potential of the battery $V_{bat}$, of the intensity of the load current $i_{load}$ and of the temperature T.

For a better accuracy, the battery should be in a relaxed phase.

When the device is switched on, the battery is always active, even when the device is in standby, because of some periodic current pulses due to radio-frequency communications constantly on-going. The pulse amplitudes depend on the distance to the base station and on characteristics of the communication channel between the device and the base station (e.g. on the RF "shield" created by the environment). In general, the amplitude ranges from 60 mA to 120 mA. The pulse period depends on the communication technology (GSM, WCDMA, etc.).

The battery is at closest of the relaxed phase between these pulses and far enough from them. In practice, such measurements are complex to implement.

However, the initialization process of an embodiment of the invention can be based only on measurements when the battery is inserted into the mobile telecommunication device or when the latter is switched on after a substantial time off. This is here a further advantage of the invention.

Then in step E02, the internal resistance of the battery is computed.

According to embodiments of the invention, it can be taken into account that some of the variables of the equations above are dependent on parameters like the temperature for instance.

It is notably the case of the internal resistance R of the battery. This internal resistance R does not vary too much with the temperature, whatever the voltage, in comparison of the impedance of the battery. Furthermore, the internal resistance is not dependent on other external parameters. This is a further advantage of the invention to limit the dependency on temperature variations, which can easily be taken into account. In other words, the internal resistance can be accurately modeled.

It is interesting to take this limited dependency on temperature T into account in order to reach a more important level of accuracy. For instance, the resistance R can be determined by the following equation:

$$R = R_{Tinit} \cdot \left[ 1 + T_{coef} \cdot \left( T - T_{init} \right) \right]$$

Where $T_{init}$ is the reference temperature and $T_{coef}$ is a temperature variation coefficient. $R_{Tinit}$ is the resistance at the reference temperature $T_{init}$. In other words, the resistance R is given as function of a constant term $R_{Tinin}$ and of a variable term $R_{tinit}[T_{coef} \cdot (T-T_{init})]$.

These coefficients can be determined empirically by making tests for the types of batteries to be used.

The values of these parameters can be determined by experimentations.

In order to get robust values, these experimentations may comprise making measurements on several different discharge current (for instance 4) and on several different batteries of the same type (for instance 3) in order to take into account the variability of the battery's parameters. The same process may apply for other parameters of the algorithms, like the base voltage $E_0$ and the battery coefficient K.

Consequently, once these parameters configured, the internal resistance R can be fully determined from a measurement of the temperature T.

When the value of the internal resistance R is determined, the maximum charge $Q_{max}$ can be computed at the next step E03.

This value can be simply given by the equation already provided above:

$$Q_{max} = 60 \cdot T_{max} \cdot i_{load}$$

Wherein

$$T_{max}=60.[(Q_i/I_{load}) + (K.Q_i/\Delta)]$$

and

$$\Delta = V_{cut-off} - E_0 + R.i_{load}$$

From the determination of the internal resistance R, the open-circuit voltage $V_{OC}$ can also be determined during a step E04. The open-circuit voltage Voc can be determined from the battery voltage $V_{bat}$ compensated by a drop constituted by the internal resistance multiplied by the load current intensity $i_{load}$:

$$V_{OC} = V_{bat}+R.i_{load}$$

It should be noted that despite in the described embodiment the steps E03, E04, E05 are performed in sequence, other arrangements can be possible. Indeed, since the computation of the open-circuit voltage $V_{OC}$ , for example, does not depend on the maximum charge $Q_{max}$, the latter can be computed after the determination of this voltage $V_{OC}$. The man skilled-in-the-art is naturally able to determine further arrangement using his own personal knowledge in algorithm design.

Then, from the open-circuit voltage $V_{OC}$, an initial value of the SoC can be determined at step E05, from, for instance, a look-up table.

The look-up table comprises associations between possible values of the open-circuit voltage and corresponding values for the State of Charge, SoC. For instance, it may look like:

| $V_{CO1}$ | SoC1 |
| --- | --- |
| $V_{OC2}$ | $SoC_2$ |
| $V_{OC3}$ | $SOC_3$ |
| $V_{OC4}$ | $SoC_4$ |

According to an embodiment of the invention, the closest value $V_{OC1}$, $V_{OC2}$, $V_{OC3}$, $V_{OC4...}$ is searched in this lookup table, and the corresponding value of the SoC is provided.

According to another embodiment, the look-up table is ordered and a matching value $V_{OCi}$ is determined so that the determined value is comprised in the interval $[V_{OCi}; V_{OCi+1}]$ and the corresponding value for the SoC is determined as an interpolation between the 2 values corresponding to the limits $V_{OCi}$, $V_{OCi+1}$. The interpolation can be a linear one.

Once this initial SoC is determined, the initial value of the load $Q_{start}$ can be determined at a step E06 by the simple equation:

$$Q_{start} = \frac{SoC}{100} \times Q_{max}$$

Then, the algorithm can pursue with the determination of the State of Charge SoC by the coulomb counter at step E5, or a first iteration can be initiated directly by moving to step E1. The coulomb counter of step E5 will be explained later.

Turning now to FIG. 4, an iterative process will be explained for determining iterative values for the SoC. Each iteration (or loop) corresponds to a time period set in advance. This time period is tuned according to the resources of the device which are planned to be devoted to this task, as well as the objective of this SoC determination: for instance, if the objective is only to display the remaining battery time to the end user, the time period can be set to a few minutes. If, however, some applications should be triggered according to the value of the SoC (or remaining battery time), shorter time periods may be provisioned.

The Step E0 corresponds to an initialization algorithm like the one which has been described above. It can encompass the steps E01, E02, E03, E04, E05, E06 previously explained.

The step E1 consists in determining current values of the voltage or potential of the battery $V_{bat}$, of the load current $i_{load}$ and of the temperature T. This step is similar to the initialization step E01.

The next step E2 may consist in determining the resistance R, in a similar way as explained above in connection with step E02.

As the resistance R depends on the measured temperature according to the equation $R = R_{Tinit} \cdot \lfloor 1 + T_{coef}(T - T_{init})\rfloor$, its value can be updated at each iteration as a function of the new measurement for the temperature.

The algorithm may however be simplified by keeping the resistance R constant and independent of the measured temperature T without departing from the invention.

The next step E3 consists in determining the coefficient K, as defined in the Shepherd's model. This coefficient K can be determined in several manners.

A possible embodiment is depicted in FIG. 5 and consists in iterative steps.

A first value for the coefficient K is determined in step E31. This first value can be based on the value determined at previous iteration of the algorithm. The initial value can be determined by experiments and set up as a configuration parameter of the algorithm. This parameter may depend on the temperature. At 23 Celsius, it may be below 0.1. Depending on the current temperature, it may increases to reach a value below 1.

Then, in a step E32, the Shepherd's model is used to compute an estimated value of the battery voltage $V_{bat}$:

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

In this equation, the time t represents the time between two iterations. Therefore the product "$i_{load}.t$" represents the differential charge that has been consumed between two iterations (i.e. between two estimations of the State of Charge).

Then, at step E33, this estimated value $V^*_{bat}$ is compared with the measured voltage $V_{bat}$. If they are close enough, it means that the current value for the parameter K is good and that the algorithm can use the current value. The process then moves on to the step E4.

Otherwise, the current value for the coefficient K is considered as not good enough and the process can loop back to update the current value of K at step E31. The re-estimation of the parameter K can be done according to the result of the comparison done in the step E33.

The step E4 consists in determining the maximum charge $Q_{max}$ according notably to the current value of the coefficient K, considered as a good enough approximation. This value of the coefficient K could have been provided by an implementation based on the previously-described steps in connection with FIG. 5 or by other implementations.

The step E4 may consists in determining firstly the maximum discharge time $T_{max}$ and then the maximum charge $Q_{max}$.

As described above, these values can be determined by the equation:

$$Q_{max} = 60.T_{max} \cdot i_{load}$$

Wherein $T_{max} = 60.[(Qi/I_{load}) + (K.Q_i/\Delta)]$ and wherein K is the current value for the parameter K and wherein $\Delta = V_{cut-off} - E_0 + R.i_{load}$.

The step E5 makes use of the Coulomb counter to determine a current value of the State of Charge SoC.

In an embodiment of the invention, a differential Coulomb counter can be implemented, so that the state of charge $SoC_i$ (of the iteration i) is estimated from its previous estimated value $SoC_{i-1}$:

$$SoC_i = SoC_{i-1} - \frac{dq_i}{Q_{max}}$$

Accordingly, the last value of the estimated $SoC_{i-1}$ is kept a buffer memory, so that it can serves as a basis for the estimation of the next value $SoC_i$.

This expression can be considered as equivalent to the expression

$$SoC = 100 \times \frac{Q_{\max} - Q_i}{Q_{\max}}$$

wherein

$$Q_i = \sum_{j=1}^{i} dq_j$$

As explained previously, the charge $dq_i = i_{load} \cdot t$ can be measured as representing the charge consumed during the time t corresponding to one iteration under the current $i_{load}$.

From the State of Charge, the remaining time can be easily determined.

One or both of these values can be transmitted to an application, running on the same device than the estimation arrangement. Applications comprise simply displaying the information on a screen of the device. This is particularly useful when the device is a mobile communication terminal (telephone, tablet, etc.) or a laptop computer, as the user needs to know in advance when its device will run out of battery.

The display may comprise the display of the actual information (percentage, remaining time in hours, minutes...), but also graphical elements (icons, etc.)

Applications may also comprise triggering of some specific actions to be undertaken when the SoC reaches a certain threshold.

This may be triggering an alert for this user. The alert may be audio.

This may also be saving open documents, to avoid recent modifications to be lost, etc.

The process can then loop back to step E1 in order to update the value of the SoC at the next time t. An exit test can be implemented on step E6 to determine if the process should loop back or be terminated.

In addition to the advantages which have been explained above throughout the description of embodiments, the invention has as a further advantage enough flexibility to take into account several additional parameters, like for instance the aging of the battery.

It is known that batteries see their behaviors impacted by their age. In the Shepherd's model, this impact can be taken into account by replacing the value of the charge Q by a function of the age.

Furthermore, in this same Shepherd's model, it can be noted that it refers to the charge Q. This charge can be estimated as a linear function of the intensity of the load current $i_{load}$.

Also, another advantage of the invention over many solutions of the prior art is that there is no need to make measurements of the Open-Circuit voltage (OCV). This is a very important advantage in the context of mobile communication terminals, due to the standby RF pulses disabling of making accurate measurements as the battery is never in a totally relaxed phase.

As it was explained above, another advantage is that the estimation of the State for Charge does not depend on the impedance of the battery but rather on its internal resistance R. This provides more robustness to the process as this latter is dependent at a small amount only on external parameters. In other words, its value can be determined accurately enough.

The State of Charge is determined mainly from the load current $i_{load}$. Its accuracy is therefore mainly dependent on the accuracy of the measurement of this load current. It is possible in art to get measurements with good precision (i.e. 12 bit ADC), and therefore to get good precision also for the estimated State of Charge.

The invention has been described with reference to preferred embodiments. However, many variations are possible within the scope of the invention.

## Claims

1. A method for estimating a charge level for a battery comprising the step of using a coulomb counter for estimating iteratively the State of Charge $SoC_i$ of said battery at a given time, from a previously estimated value $SoC_{i-1}$ by the

equation: $SoC_i = SoC_{i-1} - \dfrac{dq_i}{Q_{\max}}$ , wherein $dq_i$ is the product of said measured load current $i_{load}$ by the time between two iterations, and $Q_{max}$ is the maximum charge $Q_{max}$ of said battery, wherein said maximum charge is given by:

$$Q_{max} = 60.T_{max} \cdot i_{load} ,$$

Wherein $T_{max}=60.[(Q_i/i_{load}) + (K.Q_i/\Delta)]$ and $\Delta = V_{cut\text{-}off} - E_0 + R.i_{load}$, and wherein $i_{load}$ is the measured load current flowing through said battery, $V_{cut\text{-}off}$ is the cut-off voltage of said battery, R is the internal resistance of said battery, $E_0$ is a base voltage of said battery and K is a coefficient of said battery, said base voltage and said coefficient being defined by the Shepherd's equation

$$V_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

Wherein Q is the available charge of said battery, t is the time between two iterations and A and B are constant coefficients;

2. The method according to the previous claims, wherein said coefficient K is determined by the iterative steps of:

computing an estimated battery voltage $V^*_{bat}$ based on a current value of said coefficient K, from the equation

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

Wherein Q is the available charge of said battery, t is the time between two iterations and A and B are constant coefficients;
comparing said estimated voltage to a measured voltage and
according the comparing step, using the current value of said coefficient K or updating said current value and looping to the computing step.

3. The method according to any of previous claims wherein said resistance R is determined from a measurement of the temperature.

4. The method according to any of previous claims, wherein an initial value for said State of Charge is determined by

- Determining an open-circuit voltage $V_{OC} = V_{bat}+R.i_{load}$, wherein $V_{bat}$ is a measured battery voltage,
- Determining a corresponding State of Charge from a lookup table.

5. The method according to any of previous claims, wherein said cut-off voltage $V_{cut\text{-}off}$ is equal to 3.0 V.

6. A computer program product comprising a computer readable medium, having thereon a computer program comprising program instructions, the computer program being loadable into a data-processing unit and adapted to cause execution of the method according to any of claims 1 to 5 when the computer program is run by the data-processing unit.

7. A battery state of charge estimation arrangement for use with a battery comprising a coulomb counter for estimating iteratively the State of Charge $SoC_i$ of said battery at a given time from a previously estimated value $SoC_{i-1}$ by the equation: $SoC_i = SoC_{i-1} - \dfrac{dq_i}{Q_{max}}$ , wherein $dq_i$ is the product of said measured load current $i_{load}$ by the time between two iterations, and $Q_{max}$ is the maximum charge $Q_{max}$ of said battery, wherein said maximum charge is given by:

$$Q_{max} = 60.T_{max} \cdot i_{load} ,$$

Wherein $T_{max}=60.[(Q_i/i_{load}) + (K.Q_i/\Delta)]$ and $\Delta = V_{cut\text{-}off} - E_0 + R.i_{load}$, and R is the internal resistance of said battery, $E_0$ is a base voltage of said battery and K is a coefficient of said battery, said base voltage and said coefficient being defined by the Shepherd's equation

$$V_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

wherein Q is the available charge of said battery, t is the time between two iterations and A and B are constant coefficients;
and,means for measuring said load current $i_{load}$ flowing through said battery, a cut-off voltage $V_{cut\text{-}off}$ of said battery,

**8.** The estimation arrangement according to claim 7, further comprising determining means for determining said coefficient K by:

computing an estimated battery voltage $V^*_{bat}$ based on a current value of said coefficient K, from the equation

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

Wherein Q is the available charge of said battery, t is the time between two iterations and A and B are constant coefficients;
comparing said estimated voltage to a measured voltage and means for, according to the result of said comparing, using the current value of said coefficient K, or updating said current value and triggering said determining means.

**9.** The estimation arrangement according to any of claims 7 to 8, further comprising means for measuring a temperature and means for determining said resistance R from a measurement of said temperature.

**10.** The estimation arrangement according to any of claims 7 to 9, comprising means for determining an initial value for said State of Charge by:

- Determining an open-circuit voltage $V_{OC} = V_{bat}+R.i_{load}$, wherein $V_{bat}$ is a measured battery voltage,
- Determining a corresponding State of Charge from a lookup table.

**11.** Mobile communication terminal comprising an estimation arrangement according to any of claims 7 to 10 and a battery.

**Patentansprüche**

**1.** Verfahren zum Schätzen eines Ladezustands für eine Batterie, das den Schritt des Verwendens eines Coulomb-Zählers zum iterativen Schätzen des Ladestatus $SoC_i$ der Batterie an einem gegebenen Zeitpunkt von einem zuvor geschätzten Wert $SoC_{i-1}$ durch die folgende Gleichung: $SoC_i = SoC_{i-1} - \frac{dq_i}{Q_{max}}$ umfasst, wobei $dq_i$ das Produkt des gemessenen Ladestroms $i_{load}$ mit der Zeit zwischen zwei Iterationen ist und $Q_{max}$ die maximale Ladung $Q_{max}$ der Batterie ist, wobei die maximale Ladung durch Folgendes gegeben ist:

$$Q_{max} = 60 \cdot T_{max} \cdot i_{load}$$

wobei $T_{max} = 60 \cdot [(Q_i/i_{load}) + (K \cdot Q_i/\Delta)]$ und $\Delta = V_{cut\text{-}off} - E_0 + R \cdot i_{load}$ und wobei $i_{load}$ der gemessene Ladestrom ist, der durch die Batterie fließt, $V_{cut\text{-}off}$ die Endspannung der Batterie ist, R der Innenwiderstand der Batterie ist, $E_0$ eine Basisspannung der Batterie und K ein Koeffizient der Batterie ist, wobei die Basisspannung und der Koeffizient durch die Shepherd-Gleichung definiert sind:

$$V_{bat} = E_0 - K \cdot i_{load} \cdot \left( \frac{Q}{Q - i_{load} \cdot t} \right) - R \cdot i_{load} + A \cdot e^{-B \cdot i_{load} \cdot t/Q}$$

wobei Q die verfügbare Ladung der Batterie ist, t die Zeit zwischen zwei Iterationen ist und A und B konstante Koeffizienten sind.

2. Verfahren nach dem vorhergehenden Anspruch, wobei der Koeffizient K durch die folgenden iterativen Schritte bestimmt wird:

Berechnen einer geschätzten Batteriespannung V*$_{bat}$ auf der Grundlage eines gegenwärtigen Werts des Koeffizienten K von der folgenden Gleichung:

$$V_{bat}^* = E_0 - K \cdot i_{load} \cdot \left( \frac{Q}{Q - i_{load} \cdot t} \right) - R \cdot i_{load} + A \cdot e^{-B \cdot i_{load} \cdot t/Q}$$

wobei Q die verfügbare Ladung der Batterie ist, t die Zeit zwischen zwei Iterationen ist und A und B konstante Koeffizienten sind;
Vergleichen der geschätzten Spannung mit einer gemessenen Spannung und
gemäß dem Vergleichsschritt, Verwenden des gegenwärtigen Werts des Koeffizienten K oder Aktualisieren des gegenwärtigen Werts und Schleifen zum Berechnungsschritt.

3. Verfahren nach einem der vorhergehenden Ansprüche, wobei der Widerstand R von einer Messung der Temperatur bestimmt wird.

4. Verfahren nach einem der vorhergehenden Ansprüche, wobei ein Ausgangswert für den Ladestatus durch Folgendes bestimmt wird:

- Bestimmen einer Leerlaufspannung $V_{OC} = V_{bat} + R.i_{load}$, wobei $V_{bat}$ eine gemessene Batteriespannung ist,
- Bestimmen eines entsprechenden Ladestatus von einer Nachschlagtabelle.

5. Verfahren nach einem der vorhergehenden Ansprüche, wobei die Endspannung $V_{cut-off}$ gleich 3.0 V ist.

6. Computerprogrammprodukt, das ein maschinenlesbares Medium umfasst, das darauf ein Computerprogramm aufweist, das Programmbefehle umfasst, wobei das Computerprogramm in eine Datenverarbeitungseinheit geladen werden kann und angepasst ist, um die Ausführung des Verfahrens nach einem der Ansprüche 1 bis 5 zu bewirken, wenn das Computerprogramm durch die Datenverarbeitungseinheit ausgeführt wird.

7. Batterieladestatus-Schätzungsanordnung zur Verwendung mit einer Batterie, die einen Coulomb-Zähler zum iterativen Schätzen des Ladestatus $SoC_i$ der Batterie an einem gegebenen Zeitpunkt von einem zuvor geschätzten Wert $SoC_{i-1}$ durch die folgende Gleichung: $SoC_i = SoC_{i-1} - \frac{dq_i}{Q_{max}}$ umfasst, wobei $dq_i$ das Produkt des gemessenen Ladestroms $i_{load}$ mit der Zeit zwischen zwei Iterationen ist und $Q_{max}$ die maximale Ladung $Q_{max}$ der Batterie ist, wobei die maximale Ladung durch Folgendes gegeben ist:

$$Q_{max} = 60 \cdot T_{max} \cdot i_{load}$$

wobei $T_{max} = 60 \cdot [(Q_i/i_{load}) + (K \cdot Q_i/\Delta)]$ und $\Delta = V_{cut-off} - E_0 + R \cdot i_{load}$ und R der Innenwiderstand der Batterie ist, $E_0$ eine Basisspannung der Batterie und K ein Koeffizient der Batterie ist, wobei die Basisspannung und der Koeffizient durch die Shepherd-Gleichung definiert sind:

$$V_{bat} = E_0 - K \cdot i_{load} \cdot \left( \frac{Q}{Q - i_{load} \cdot t} \right) - R \cdot i_{load} + A \cdot e^{-B \cdot i_{load} \cdot t/Q}$$

wobei Q die verfügbare Ladung der Batterie ist, t die Zeit zwischen zwei Iterationen ist und A und B konstante Koeffizienten sind;
und Mittel zum Messen des Ladestroms $i_{load}$, der durch die Batterie fließt, einer Endspannung $V_{cut-off}$ der Batterie.

8. Schätzungsanordnung nach Anspruch 7, die ferner Mittel zum Bestimmen des Koeffizienten K durch Folgendes umfasst:

Berechnen einer geschätzten Batteriespannung $V^*_{bat}$ auf der Grundlage eines gegenwärtigen Werts des Koeffizienten K von der folgenden Gleichung:

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t/Q}$$

wobei Q die verfügbare Ladung der Batterie ist, t die Zeit zwischen zwei Iterationen ist und A und B konstante Koeffizienten sind;
Vergleichen der geschätzten Spannung mit einer gemessenen Spannung und
Mittel zum Verwenden des gegenwärtigen Werts des Koeffizienten K oder Aktualisieren des gegenwärtigen Werts und Auslösen des Bestimmungsmittels gemäß dem Ergebnis des Vergleichens.

9. Schätzungsanordnung nach Anspruch 7 oder 8, die ferner Mittel zum Messen einer Temperatur und Mittel zum Bestimmen des Widerstands R von einer Messung der Temperatur umfasst.

10. Schätzungsanordnung nach einem der Ansprüche 7 bis 9, die Mittel zum Bestimmen eines Ausgangswerts für den Ladestatus durch Folgendes umfasst:

- Bestimmen einer Leerlaufspannung $V_{OC} = V_{bat}+R.i_{load}$, wobei $V_{bat}$ eine gemessene Batteriespannung ist,
- Bestimmen eines entsprechenden Ladestatus von einer Nachschlagtabelle.

11. Mobilkommunikationsendgerät, das eine Schätzungsanordnung nach einem der Ansprüche 7 bis 10 und eine Batterie umfasst.

**Revendications**

1. Procédé pour estimer un niveau de charge d'une batterie comprenant l'étape consistant à utiliser un compteur de Coulomb pour estimer de manière itérative l'état de charge $SoC_i$ de ladite batterie à un instant donné à partir d'une valeur estimée précédemment $SoC_{i-1}$ par l'équation :

$$SoC_i = SoC_{i-1} - \frac{dq_i}{Q_{\max}},$$

dans lequel $dq_i$ est le produit dudit courant de charge $i_{load}$ mesuré et du temps écoulé entre deux itérations, et $Q_{max}$ est la charge maximale $Q_{max}$ de ladite batterie, dans lequel ladite charge maximale est donnée par :

$$Q_{\max} = 60.T_{\max} \cdot i_{load}$$

dans lequel $T_{max}=60.[(Q_i/i_{load}) + (K.Q_i/\Delta)]$ et $\Delta = V_{cut-off} - E_0 + R.i_{load}$, dans lequel $i_{load}$ est le courant de charge mesuré circulant à travers ladite batterie, $V_{cut-off}$ est la tension de coupure de ladite batterie, et R est la résistance interne de ladite batterie, $E_0$ est une tension de base de ladite batterie et K est un coefficient de ladite batterie, ladite tension de base et ledit coefficient étant défini par l'équation de Shepherd :

$$V_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

dans lequel Q est la charge disponible de ladite batterie, t est le temps écoulé entre deux itérations et A et B sont des coefficients constants.

2. Procédé selon les revendications précédentes, dans lequel ledit coefficient K est déterminé par les étapes itératives consistant à :

calculer une tension de batterie estimée $V^*_{bat}$ sur la base d'une valeur actuelle dudit coefficient K, à partir de l'équation

$$V^*_{bat} = E_0 - K \cdot i_{load} \cdot \left( \frac{Q}{Q - i_{load} \cdot t} \right) - R \cdot i_{load} + A \cdot e^{-B \cdot i_{load} \cdot t / Q}$$

dans lequel Q est la charge disponible de ladite batterie, t est le temps écoulé entre deux itérations et A et B sont des coefficients constants ;
comparer ladite tension estimée à une tension mesurée, et
en fonction du résultat de ladite comparaison, utiliser la valeur actuelle dudit coefficient K, ou mettre à jour ladite valeur actuelle et boucler à l'étape de calcul.

3. Procédé selon l'une quelconque des revendications précédentes, dans laquelle ladite résistance R est déterminée à partir d'une mesure de la température.

4. Procédé selon l'une quelconque des revendications précédentes, dans lequel une valeur initiale pour ledit état de charge est déterminée par

- la détermination d'une tension en circuit ouvert $V_{OC} = V_{bat} + R.i_{load}$, dans lequel $V_{bat}$ est une tension de batterie mesurée,
- la détermination d'un état de charge correspondant à partir d'une table de consultation.

5. Procédé selon l'une quelconque des revendications précédentes, dans lequel ladite tension de coupure $V_{cut-off}$ est égale à 3,0 V.

6. Produit de programme informatique comprenant un support lisible par ordinateur, ayant un programme d'ordinateur comprenant des instructions de programme, le programme d'ordinateur pouvant être chargé dans une unité de traitement de données et adapté pour provoquer la mise en oeuvre du procédé selon l'une quelconque des revendications 1 à 5 lorsque le programme d'ordinateur est mise en oeuvre par l'unité de traitement de données.

7. Agencement d'estimation d'état de charge d'une batterie pour une utilisation avec une batterie comprenant un compteur de Coulomb pour estimer de manière itérative l'état de charge $SoC_i$ de ladite batterie à un instant donné à partir d'une valeur estimée précédemment $SoC_{i-1}$ par l'équation :

$$SoC_i = SoC_{i-1} - \frac{dq_i}{Q_{max}},$$

dans lequel $dq_i$ est le produit dudit courant de charge $i_{load}$ mesuré et du temps écoulé entre deux itérations, et $Q_{max}$ est la charge maximale $Q_{max}$ de ladite batterie, dans lequel ladite charge maximale est donnée par:

$$Q_{\max} = 60.T_{\max}\cdot i_{load}$$

dans lequel $T_{max}=60.[(Q_i/i_{load}) + (K.Q_i/\Delta)]$ et $\Delta = V_{cut\text{-}off} - E_0 + R.i_{load}$, et R est la résistance interne de ladite batterie, $E_0$ est une tension de base de ladite batterie et K est un coefficient de ladite batterie, ladite tension de base et ledit coefficient étant défini par l'équation de Shepherd :

$$V_{bat} = E_0 - K\cdot i_{load}\cdot\left(\frac{Q}{Q - i_{load}\cdot t}\right) - R\cdot i_{load} + A\cdot e^{-B\cdot i_{load}\cdot t/Q}$$

dans lequel Q est la charge disponible de ladite batterie, t est le temps écoulé entre deux itérations et A et B sont des coefficients constants ; et

des moyens pour mesurer ledit courant de charge $i_{load}$ circulant à travers ladite batterie, une tension de coupure $V_{cut\text{-}off}$ de ladite batterie.

8. Agencement d'estimation selon la revendication 7, comprenant en outre un moyen de détermination pour déterminer ledit coefficient K par:

le calcul d'une tension de batterie estimée $V^*_{bat}$ sur la base d'une valeur actuelle dudit coefficient K, à partir de l'équation

$$V^*_{bat} = E_0 - K\cdot i_{load}\cdot\left(\frac{Q}{Q - i_{load}\cdot t}\right) - R\cdot i_{load} + A\cdot e^{-B\cdot i_{load}\cdot t/Q}$$

dans lequel Q est la charge disponible de ladite batterie, t est le temps écoulé entre deux itérations et A et B sont des coefficients constants ;

le comparaison de ladite tension estimée à une tension mesurée, et

des moyens pour, en fonction du résultat de ladite comparaison, utiliser la valeur actuelle dudit coefficient K, ou mettre à jour ladite valeur actuelle et déclencher lesdits moyens de détermination.

9. Agencement d'estimation selon l'une quelconque des revendications 7 à 8, comprenant en outre un moyen pour mesurer une température et un moyen pour déterminer ladite résistance R à partir d'une mesure de ladite température.

10. Agencement d'estimation selon l'une quelconque des revendications 7 à 9, comprenant des moyens pour déterminer une valeur initiale pour ledit état de charge par:

- détermination d'une tension en circuit ouvert $V_{OC}= V_{bat}+R.i_{load}$, dans lequel $V_{bat}$ est une tension de batterie mesurée,

- détermination d'un état de charge correspondant à partir d'une table de consultation.

11. Terminal de communication mobile comprenant un agencement d'estimation selon l'une quelconque des revendications 7 à 10, et une batterie.

**FIG. 1**

**FIG. 2**

$V_{bat}$ ?
$I_{load}$ ?
T ?

E01

R ?

E02

$Q_{max}$ ?

E03

$V_{OCV}$ ?

E04

SoC ?

E05

$Q_{start}$ ?

E06

E5      E1

FIG. 3

FIG. 4

K ?

E31

V$_{bat}$ ?

E32

Cond ?

E33

E3

T$_{max}$ ?
Q$_{max}$ ?

E4

SoC ?

E5

**FIG. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• Design of Primary and Secondary Cells. *Journal of The Electrochemical Society,* 1965, vol. 112, 657-664